# EUROPEAN PATENT APPLICATION

(11) **EP 1 786 128 A1**
(43) Date of publication of application: **16.05.2007**
(21) Application number: 05772709.1
(22) Date of filing: 16.08.2005
(51) Int. Cl.: H04J 11/00, H04B 1/04

(54) **PEAK POWER SUPPRESSING APPARATUS AND PEAK POWER SUPPRESSING METHOD**

(30) Priority: 30.08.2004 JP 2004250523
(71) Applicant: MATSUSHITA ELECTRIC INDUSTRIAL CO., LTD., Kadoma-shi, Osaka Osaka 571-0051 (JP)
(72) Inventor: TAKABAYASHI, Shinichiro c/o Matsushita El.In.Co.Lt, Chuo-ku, Osaka-shi, Osaka 540-6319 (JP)
(74) Representative: Grünecker, Kinkeldey, Stockmair & Schwanhäusser Anwaltssozietät
(86) International application number: PCT/JP2005/014955
(87) International publication number: WO 2006/025213

(57) **Abstract**

A peak power suppressing apparatus capable of improving the reception error rate characteristic of an apparatus on a reception side. In this apparatus, a clipping part (102) clips an input signal, thereby suppressing the peak power of the signal. A subtracting circuit (104) extracts an in-band distortion component of the peak power suppressed signal. A subtracting circuit (111) subtracts the extracted in-band distortion component from the peak power suppressed signal, thereby removing the residual distortion component in the band of the peak power suppressed signal.

## Description

### Technical Field

The present invention relates to peak power suppression apparatus and peak power suppression methods. More particularly, the present invention relates to peak power suppression apparatus and peak power suppression methods used in an OFDM (Orthogonal Frequency Division Multiplex) scheme wireless transmission apparatus.

### Background Art

Demand for high-speed, high-volume communications in mobile communications has increased in recent years. As a modulating scheme for fulfilling that demand, the OFDM scheme has gained attention. A multi-carrier signal with a plurality of subcarriers arranged orthogonal on the frequency axis is used with the OFDM scheme. The multi-carrier signal is obtained by combining a plurality of carriers, which often produces high peak power. As an index to indicate the size of the peak power, a PAPR (Peak to Average Power Ratio) value has been used for example, but as the number of subcarriers increase with the OFDM scheme, this PAPR value also increases.

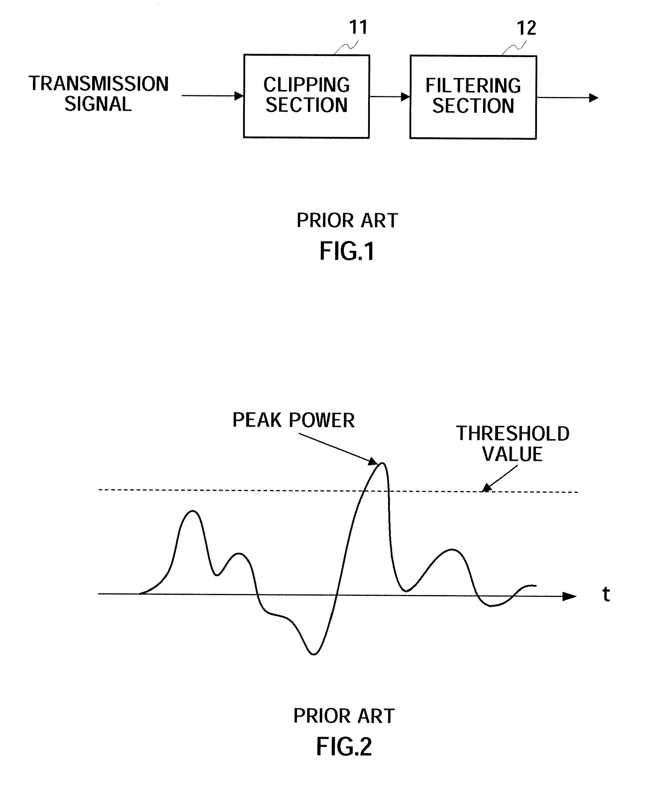

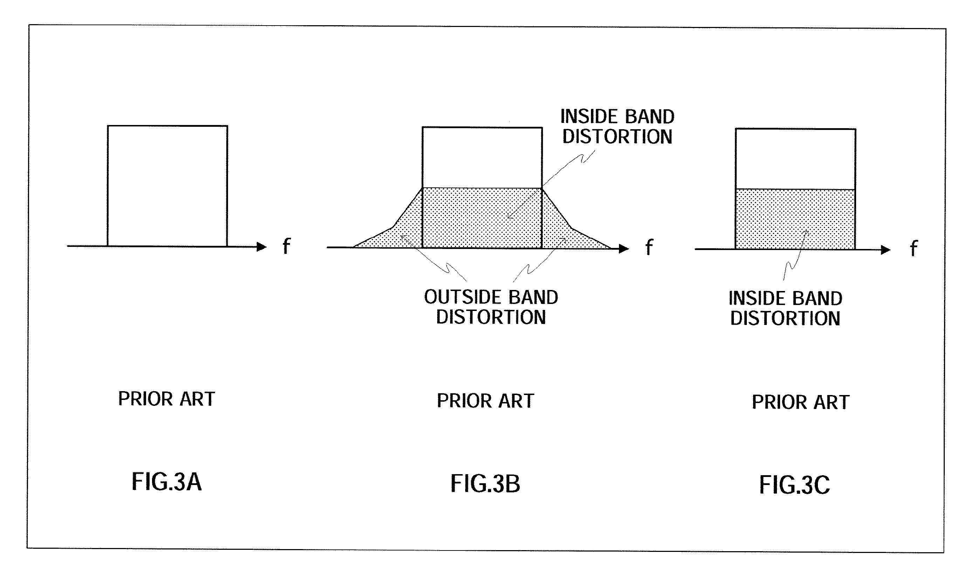

Conventionally, in a scheme to suppress peak power, a method called "clipping and filtering," disclosed in Patent document 1, has been employed. The following will explain the operation of the clipping and filtering method with reference to the drawings provided. FIG. 1 is a block diagram showing an example configuration of a conventional peak power suppression apparatus that implements the clipping and filtering method. When an amplitude value of a transmitted signal increases in size beyond a predetermined threshold value, as shown in FIG. 2, the amplitude value is restricted by the clipping of clipping section 11. If this process is viewed at the frequency axis, the distortion component caused by the clipping of the transmission signal having the spectrum shown in FIG.3A appears inside and outside the band of the transmission signal, as shown in FIG.3B. The distortion component outside of the band that may interfere with adjacent channels is eliminated by filtering section 12 to attain a transmission signal having a spectrum as shown in FIG.3C.
Patent Document 1: Japanese Patent Application Laid-Open No.2002-185432

### Disclosure of the Invention

### Problem to be Solved by the Invention

However, in the conventional peak power suppression apparatus described above, although the distortion component outside of the band of the transmission signal can be eliminated by filtering, the distortion component inside the band of the transmission signal is not eliminated by filtering and remains as it is in the transmission signal. Therefore, if signals with the distortion component inside the band are sent to a reception apparatus, there is a problem that the reception error rate characteristic on the reception apparatus is degraded.

It is therefore an object of the present invention is to provide a peak power suppression apparatus and a peak power suppression method that improve the reception error rate characteristic on the reception apparatus.

### Means of Solving the Problem

The peak power suppression apparatus of the present invention employs a configuration having: a suppression section that suppresses a peak power of a signal; a sampling section that samples a distortion component inside a band of the signal whose peak power is suppressed; and a removing section that removes the sampled distortion component inside the band from the signal whose peak power is suppressed.

The peak power suppression apparatus of the present invention has: suppressing a peak power of a signal; sampling a distortion component inside a band of the signal whose peak power is suppressed; and removing the sampled distortion component inside the band from the signal whose peak power is suppressed.

### Advantageous Effect of the Invention

According to the present invention, the reception error rate characteristic of a reception apparatus is improved.

### Brief Description of Drawings

FIG.1 is a block diagram showing an example configuration of a conventional peak power suppression apparatus;
FIG.2 is a view of an example of an amplitude value of a transmission signal;
FIG's. 3A, 3B, and 3C are views of a transmission signal spectrum according to a conventional peak power suppression apparatus;
FIG.4 is a block diagram showing a configuration of a wireless transmission apparatus according to a first embodiment of the present invention;
FIG's. 5A, 5B, 5C, 5D, and 5E are block diagrams of a transmission signal spectrum according to a first embodiment of the present invention;
FIG.6 is a block diagram showing a configuration of a wireless transmission apparatus according to a second embodiment of the present invention;
FIG.7 is a block diagram showing a configuration of a wireless transmission apparatus according to a third embodiment of the present invention; and
FIG.8 is a flowchart of an operation of a wireless transmission apparatus according to the third embodiment of the present invention.

### Best Mode for Carrying Out the Invention

Preferred embodiments of the present invention will be explained below in detail with reference to the accompanying drawings.

### (Embodiment 1)

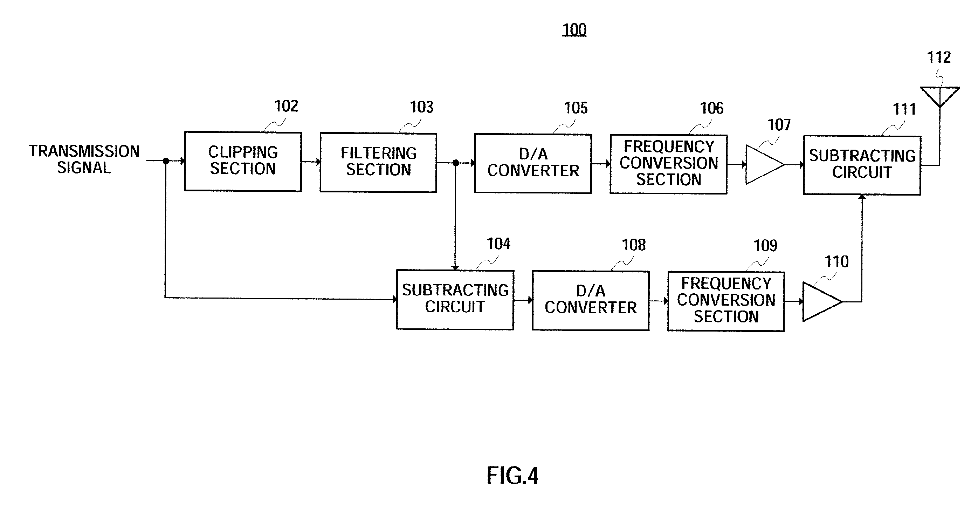

FIG.4 is a block diagram of a configuration of a wireless transmission apparatus that adopts the peak power suppression apparatus according to a first embodiment of the present invention.

Wireless transmission apparatus 100 of FIG. 4 has: clipping section 102; filtering section 103; subtracting circuit 104; D/A converter 105; frequency conversion section 106; power amplifier 107; D/A converter 108; frequency conversion section 109; power amplifier 110; subtracting circuit 111; and antenna 112.

Clipping section 102 as the suppression means clips the amplitude component of the transmission signal above a threshold value. This enables the peak power of the transmission signal to be suppressed. Filtering of the output signals of the clipping section 102 is performed at filtering section 103 and the distortion component outside the band of the transmission signal is removed. The output signal of filtering section 103 is converted from a digital signal to an analog signal at D/A converter 105. The output signal of D/A converter 105 is frequency-converted to a RF (radio frequency) signal of from the baseband signal, at frequency conversion section 106. The output signal of frequency conversion section 106 is amplified at power amplifier 107 as a first amplification means belonging to a main transmission system. The original transmission signal, specifically the transmission signal just prior to filtering is subtracted from the output signal of filtering section 103 at subtracting circuit 104 as the sampling means, and the distortion component inside the band of the transmission signal is sampled. The output signal of subtracting circuit 104, specifically the distortion component inside the band, is converted from a digital signal to an analog signal at D/A converter 108. The output signal of D/A converter 108 is frequency-converted to an RF signal from the baseband signal, at frequency conversion section 109. The output signal of frequency conversion section 109 is amplified at power amplifier 110 as a second amplifying means belonging to a sub-transmission system. By subtracting the output signal of power amplifier 110 from the output signal of power amplifier 107 at subtracting circuit 111 as the removing means, the distortion component inside the band is removed from the transmission signal. The transmission signal with the distortion component inside the band removed is wirelessly transmitted from antenna 112.

The following will explain the operations of wireless transmission apparatus 100 having the aforementioned configuration with reference to FIG's.5A to 5E.

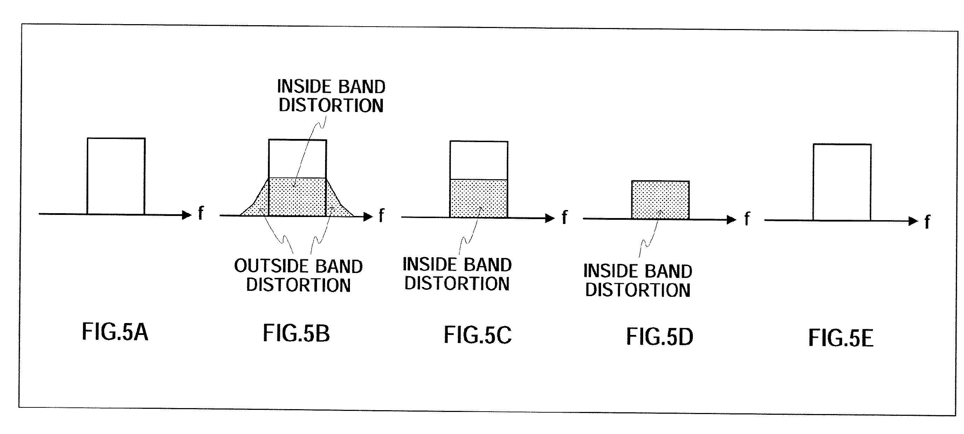

The transmission signal inputted to clipping section 102 has a spectrum as shown in FIG. 5A, for example. Also, the transmission signal undergoes clipping at clipping section 102. In this process, the amplitude component that exceeds a predetermined threshold value is restricted, whereby the peak power is suppressed. Here, the aforementioned threshold value is determined based on the PAPR value determined according to the design. For example, if the PAPR value is 6 dB, the threshold value is set to 6 dB higher than the average signal power. As shown in FIG. 5B, the distortion component is included both inside and outside the band of the transmission signal, in the clipped transmission signal.

Also, the clipped transmission signal undergoes filtering at filter section 103. With this process, the distortion component outside the band is removed, as shown in FIG. 5C. At that point, the distortion component inside the band remains in the transmission signal.

The transmission signal outputted from filtering section 103 undergoes D/A conversion and frequency conversion at D/A converter 105 and frequency conversion section 106, and is then amplified by power amplifier 107.

On the other hand, the original transmission signal from the output signal of filtering section 103 is subtracted at subtracting circuit 104. The result is that the distortion component inside the band of the transmission signal is removed, as shown in FIG.5D. The removed distortion component inside the band is amplified at power amplifier 110. Note that because only the distortion component inside the band is amplified at power amplifier 110 of the sub-transmission system, it is acceptable to use an amplifier having a lower output characteristic in comparison to power amplifier 107 of the main transmission system.

Also, distortion component inside the band as the output signal of power amplifier 110 is subtracted from the transmission signal as the output signal of power amplifier 107, at subtracting circuit 111. This removes the distortion component inside the band from the transmission signal. The transmission signal obtained as a result of this has a spectrum as shown in FIG.5E, for example.

In this way, the distortion component inside the band is removed from the transmission signal whose peak power is suppressed, according to the present invention. Therefore, the reception error rate characteristic of the reception apparatus is improved.

Furthermore, according to the present invention, because the distortion component inside the band is removed from the amplified transmission signal, peak power is regenerated on the time axis by the removal of the distortion component inside the band and the PAPR value is increased. However, the PAPR value can be suppressed to below a set value at the input stage of power amplifier 107. Therefore, even if the PAPR value is increased after power amplifier 107, it is possible to prevent the affects of setting a back-off setting of power amplifier 107, specifically, a back-off value that indicates a difference between the maximum amplitude level for maintaining the linearity of power amplifier 107 and a saturation power level.

### (Embodiment 2)

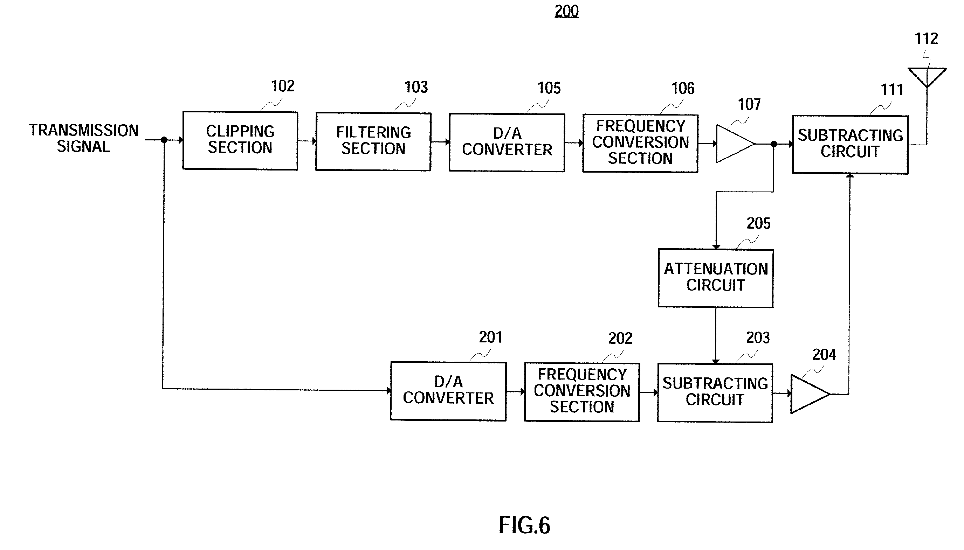

FIG.6 is a block diagram of a configuration of a wireless transmission apparatus that applies the peak power suppression apparatus according to a second embodiment of the present invention. Note that wireless transmission apparatus 200 of FIG.6 has the same basic configuration as wireless transmission apparatus 100 explained in relation to the first embodiment, so the same components are assigned same reference numerals. Thus, explanations thereof will be omitted.

Insteadof subtracting circuit 104; D/Aconverter 108; frequency conversion section 109 and power amplifier 110 explained in relation to the first embodiment, D/A converter 201; frequency conversion section 202, subtracting circuit 203 and power amplifier 204 are provided on wireless transmission apparatus 200, and attenuating circuit 205 is also added.

The original signal is converted from a digital signal to an analog signal at D/A converter 201. The output signal of D/A converter 201 is converted to an RF signal from the baseband signal, at frequency conversion section 202.

The output signal of power amplifier 107 is attenuated at attenuating circuit 205. The output signal of frequency conversion section 202 is subtracted from the output signal of power amplifier 107 at subtracting circuit 203 as the sampling means, and the distortion component inside the band of the transmission signal is sampled. At this time, the non-linear distortion component of power amplifier 107 is also sampled. The output signal of subtracting circuit 203 is amplified at power amplifier 204 as a second amplifying means belonging to the sub-transmission system.

Specifically, while the distortion component inside the band was sampled at the baseband in the first embodiment, this process is performed at the RF band in this embodiment of the present invention.

The following will explain the operations in the wireless transmission apparatus 200 having the aforementioned configuration.

The output signal of power amplifier 107 is attenuated at attenuating circuit 205. The transmission signal that underwent D/A conversion and frequency conversion at D/A converter 201 and frequency conversion section 202, is subtracted from the attenuated signal. As a result, the distortion component inside the band of the transmission signal is removed. Also, at this time, the non-linear distortion component generated at power amplifier 107 of the main transmission system is removed.

The removed distortion component inside the band and the non-linear distortion component are amplified at power amplifier 204. Because only the distortion component inside the band and the non-linear distortion component are amplified at power amplifier 204 of the sub-transmission system, it is acceptable to use an amplifier having a lower output characteristic in comparison to power amplifier 107 of the main transmission system.

Also, the distortion component inside the band as the output signal of power amplifier 204 and non-linear distortion component are subtracted from the transmission signal as the output signal of power amplifier 107, at subtracting circuit 111. This removes not only the distortion component inside the band, but also the non-linear distortion component from the transmission signal.

In this way, because the distortion component inside the band of the amplified transmission signal is sampled, not only the distortion component inside the band generated by suppression of the peak power, but also the non-linear distortion component generated by the amplification of the power amplifier 107 are sampled, and both sampled distortion components are removed, thereby further improving the reception error rate characteristic of the reception apparatus.

### (Embodiment 3)

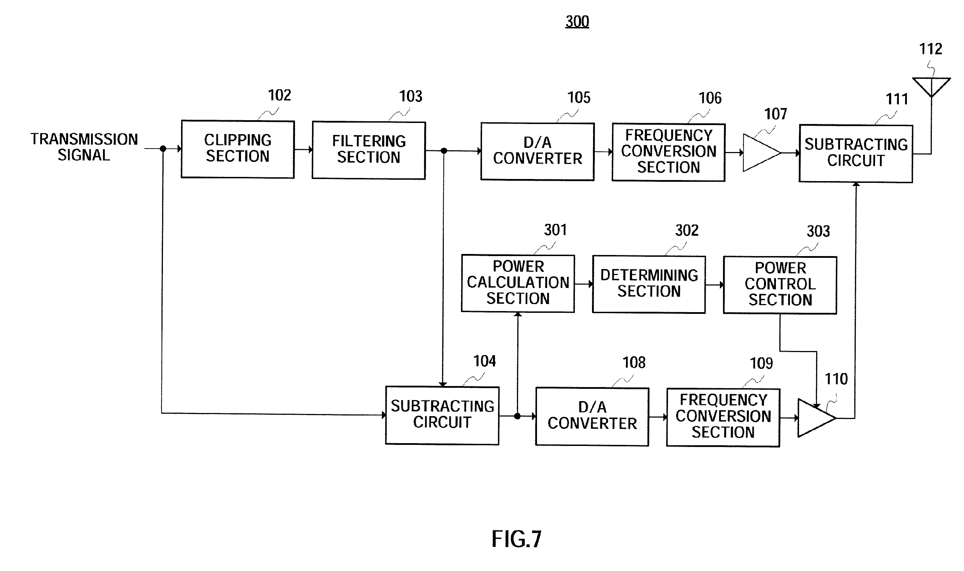

FIG.7 is a block diagram showing a configuration of a wireless transmission apparatus according to a third embodiment of the present invention. Note that the wireless transmission apparatus 300 of FIG. 7 has the same basic configuration as wireless transmission apparatus 100 explained in relation to the first embodiment, so the same components are assigned the same reference numerals. Thus, explanations thereof will be omitted.

Wireless transmission apparatus 300 has power calculation section 301; determining section 302; and power control section 303 in addition to the configuration of wireless transmission apparatus 100.

Power of the distortion component inside the band is measured at power calculation section 301 as a measuring means. It is determined whether the measured power has exceeded a threshold value at determining section 302.

The power of power amplifier 110 is controlled at power control section 303 based on the determination result of determining section 302. To explain with more detail, the operations of power amplifier 110 of the sub-transmission system are executed or halted according to the power amount of the distortion component inside the band generated by clipping. If the power amount of the distortion component inside the band is higher than the threshold value set to satisfy a predetermined error rate, the amplification operation of power amplifier 110 is executed. If it is lower, the amplification operation is halted.

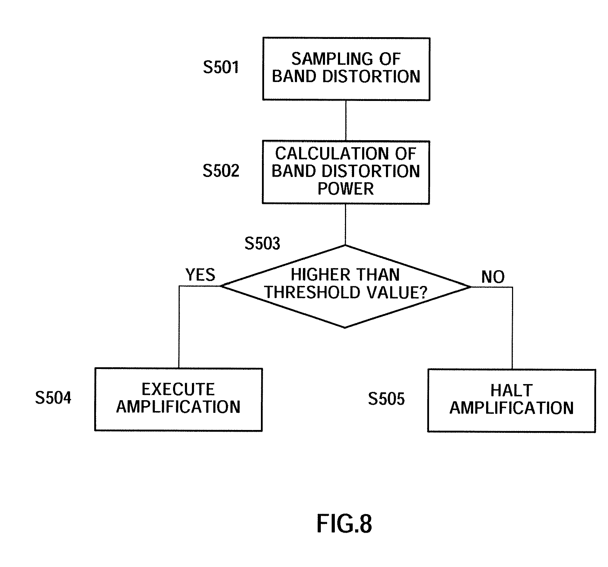

The following will explain the operations in wireless transmission apparatus 300 having the aforementioned configuration with reference to FIG.8.

Initially, the original signal and the output signal of filtering section 103 are inputted to subtracting circuit 104, and the distortion component inside the band is sampled (step S501). Then, the distortion component inside the band output from subtracting circuit 104 is inputted to power calculation section 301. The amount of power of the distortion component inside the band is measured at power calculation section 301 (step S502). As a calculating method of the amount of power, there is a method for integrating the distortion component signal over one OFDM symbol time, for example.

The amount of power outputted from power calculation section 301 is inputted to determining section 302. It is then determined at determining section 302 whether or not the amount of power is higher than the threshold value (step S503). Here, the threshold value is set so that the error rate based on a distortion component power amount to error rate characteristic found in advance through simulation is below a certain level. The determination results of determining section 302 are inputted to power control section 303. If the power amount is higher than the threshold value (S503: YES), the amplification operation of power amplifier 110 is to be executed, and power control section 303 turns on the power to power amplifier 110 (step S504). If the power amount is below the threshold value (S503: NO), the amplification operation of power amplifier 110 is to be halted, and power control section 303 turns off the power to power amplifier 110 (step S505). These operations have the effect of improving the reception error rate characteristic of the reception apparatus, and reduce the power consumption of wireless transmission apparatus 300 compared to normal operation of power amplifier 110.

Each function block employed in the description of each of the aforementioned embodiments may typically be implemented as an LSI constituted by an integrated circuit. These may be individual chips or partially or totally contained on a single chip.

"LSI" is adopted here but this may also be referred to as "IC", "system LSI", "super LSI", or "ultra LSI" depending on differing extents of integration.

Further, the method of circuit integration is not limited to LSI's, and implementation using dedicated circuitry or general purpose processors is also possible. After LSI manufacture, utilization of an FPGA (Field Programmable Gate Array) or a reconfigurable processor where connections and settings of circuit cells within an LSI can be reconfigured is also possible.

Further, if integrated circuit technology comes out to replace LSI's as a result of the advancement of semiconductor technology or a derivative other technology, it is naturally also possible to carry out function block integration using this technology. Application in biotechnology is also possible.

The present application is based on Japanese patent application No.2004-250523, filed August 30, 2004, the entire content of which is expressly incorporated herein by reference.

### Industrial Applicability

The power suppression apparatus and power suppression method of the present invention are applicable to an OFDM scheme wireless transmission apparatus that is used with a cellular telephone or wireless LAN.

## Claims

1. A peak power suppressing apparatus comprising:
a suppression section that suppresses a peak power of a signal;
a sampling section that samples a distortion component inside a band of the signal whose peak power is suppressed; and
a removing section that removes the sampled distortion component inside the band from the signal whose peak power is suppressed.

2. The peak power suppressing apparatus according to claim 1, further comprising:
a first amplification section that amplifies the signal whose peak power is suppressed; and
a second amplification section that amplifies the sampled distortion component inside the band,
wherein the removing section removes the distortion component inside the band amplified by the second amplification section from the signal amplified by the first amplification section.

3. The peak power suppressing apparatus according to claim 2, wherein the sampling section samples the distortion component inside the band of the signal amplified by the first amplification section.

4. The peak power suppressing apparatus according to claim 2, further comprising:
a measuring section that measures power of the sampled distortion component inside the band; and
a controlling section that amplifies the distortion component inside the band using the second amplification section when the measured power is above a predetermined level, and halts the amplification of the distortion component inside the band by the second amplification section when the measured power is below the predetermined level.

5. A wireless transmission apparatus comprising the peak power suppression apparatus of claim 1.

6. A peak power suppressing method comprising the steps of:
suppressing a peak power of a signal;
sampling a distortion component inside a band of the signal whose peak power is suppressed; and
removing the sampled distortion component inside the band from the signal whose peak power is suppressed.
